# EUROPEAN PATENT SPECIFICATION

(11) **EP 4 140 036 B1**
(45) Date of publication and mention of the grant of the patent: **20.09.2023**
(21) Application number: 21839625.7
(22) Date of filing: 20.12.2021
(51) Int. Cl.: H03K 17/0412, H03K 17/60

(54) **CIRCUITS INCLUDING HIGH POWER TRANSISTORS**
SCHALTUNGEN MIT HOCHLEISTUNGSTRANSISTOREN
CIRCUITS COMPRENANT DES TRANSISTORS À HAUTE PUISSANCE

(30) Priority: 20.12.2020 GB 202020216
(43) Date of publication of application: 01.03.2023
(73) Proprietor: Search for the Next Ltd, Nottingham NG7 2TU (GB)
(72) Inventor: SUMMERLAND, David, Nottingham Innovation Park Ingenuity Centre Triumph Rd Nottingham NG7 2TU (GB); LIGHT, Roger, Nottingham Innovation Park Ingenuity Centre Triumph Rd Nottingham NG7 2TU (GB); KNIGHT, Luke, Nottingham Innovation Park Ingenuity Centre Triumph Rd Nottingham NG7 2TU (GB)
(74) Representative: Tolfree, Adam Joseph Benjamin
(86) International application number: PCT/GB2021/053373
(87) International publication number: WO 2022/129952

(56) References cited:
- GB-A- 2 448 759
- US-A- 4 239 989
- US-A- 4 725 741
- US-A1- 2014 355 314
- US-A1- 2017 179 810

## Description

Bipolar Junction Transistors (BJT) used for high voltage applications, e.g. in driving circuits for alternating current (AC) electric motors, need a relatively lightly doped collector region and base region to prevent breakdown. A problem caused by light doping is high collector resistance which reduces the efficiency of the transistor. A known solution is to incorporate a drift region into the transistor.

A drift region is a weakly doped region of the collector that interfaces with the base region to provide one of the transistor's diode junctions. When the transistor is off, the drift region offers high resistance to current flow; however, when the transistor is switched on, electrons saturate the drift region lowering the resistance of the collector.

The presence of the drift region adversely slows the switching time of the transistor. This is because to turn the transistor ON the drift region needs to be charged/saturated, and to switch OFF the charge needs to dissipate. A slower switching time introduces greater inefficiency as a BJT uses more power whilst switching than when on or off.

Further, there are various applications where fast switching is desirous. An AC motor operates most efficiently when provided with an ideal sine wave; the motor speed is determined by the frequency of the sine wave that drives it. A motor drive attempts to imitate a sine wave through fast switching of its transistors. A higher switching frequency increases the accuracy that the sine wave can be approximated, especially as the motor speed increases.

Another source of inefficiency is the driver circuit used to switch the BJT which substantially continuously draws current in order to hold the BJT on and off. These inefficiencies have been avoided through the use of insulated gate bipolar transistors. GB 2 448 759 A, US 4 725 741, US 4 239 989 and US 2014/355314 each describe driver circuits for transistors that operate in a floating state.

According to a first aspect of the invention there is provided a circuit according to claim 1.

By virtue of the drift region, the BJT will remain in its ON state following switching at the driver circuit output from the ON state to the floating state.

As a result the driver circuitry needs only to provide short pulses to switch the BJT ON. This reduces the period of time during which current flows through the drive circuit per ON-OFF cycle (switching cycle), thereby reducing power consumption of the driver circuit.

Further, whilst the driver circuit output is floating and the BJT is on, the charge in the drift region will slowly dissipate. This reduces the current required to switch the transistor off.

Typically an ON-OFF cycle will comprise the following transitions in the states of the driver circuit output: ON to FLOATING, from FLOATING to OFF (whereupon the BJT turns off), from OFF to FLOATING and from FLOATING to ON (whereupon the BJT turns on).

Favourably the circuit comprises a bypass connection between the base terminal of the BJT and an emitter terminal of the BJT. The bypass connection includes a load with a resistance sized such that during the period of the ON-OFF cycle that the BJT is ON and the driver signal is FLOATING, current will discharge from the base, and thus bring the voltage of the base towards that of the emitter, at a rate slow enough that the BJT remains ON until the driver circuit output switches to OFF. The presence of the bypass circuit speeds decay of charge in the drift region whilst the transistor is ON and the driver circuit output is floating. This enables a reduced current to switch the transistor OFF at a given switching speed. To minimise the current required to switch the transistor OFF, the size of resistor is selected to reduce the voltage at the base to a value such that the transistor remains only just turned on at the end of the FLOATING period, though operation in this extreme condition may not be preferred because of lower than preferred overall power consumption characteristics.

Additionally, because the bypass connection causes the voltage at the base to be closer to that of the emitter than the collector, it ensures sufficient voltage across the reversed biased base-collector diode junction to inhibit a reduction of the depletion region at the drift region/base interface whilst the BJT is OFF and the the driver circuit output is FLOATING. This means the BJT retains its high breakdown voltage even whilst the output at the driver circuit is floating. In turn, this means the driver circuit can be controlled by the controller so as to switch from an OFF state to a floating state as soon as the BJT is OFF to reduce the power consumption of the driver circuit further. In other words, the driver circuitry need only to provide a short current pulse to switch the BJT OFF.

As a result the driver circuit need only draw current for a very short period over a complete ON-OFF switching cycle, e.g. ≤50% of the time (≤50% duty cycle) but favourably ≤5% of the time (≤5% duty cycle) and for the rest of the time maintain a floating state where no current is drawn.

The invention may, for example, be used to implement a motor driver for a multi-phase electric-motor. Where so the motor driver may comprise: a switching circuit comprising multiple bipolar junction transistors (BJT) for switching current through windings of the multi-phase electric-motor, each BJT comprising a collector drift region; a separate driver circuit associated with each BJT, each driver circuit comprising an input adapted to receive a control signal from a controller, and an output connected to a base terminal of its respective BJT; the driver circuit adapted to switch the state at its output in response to the received control signal between: an ON state that switches the transistor into an ON state; an OFF state that switches the transistor into an OFF state; and a floating state; and wherein the controller is adapted to operate the separate driver circuits such that during a complete ON-OFF switching cycle of each BJT, the output of the driver circuit is in the floating state for longer than it is in the ON state and/or the OFF state.

The invention will now be described by way of example with reference to the following figures in which:
**Figure 1A** is a schematic of control circuitry including a power bipolar junction transistor (BJT) to control current within an external circuit;
**Figure 1B** is a schematic of a discrete power BJT incorporating a drift region;
**Figure 2** are timing diagrams showing the changing state of the BJT with change in the state at the output of the driver circuit;
**Figure 3** is a circuit schematic detailing, in a simplified form, an example driver circuit structure;
**Figure 4A** is a circuit schematic illustrating a practical implementation of a driver circuit based on that of Fig 3;
**Figure 4B** are timing diagrams illustrating modelled changes in voltage and current at various points in the circuit of Figure 4A whilst operating; and
**Figure 5** is a schematic of a circuit for driving a multi-phase AC motor.

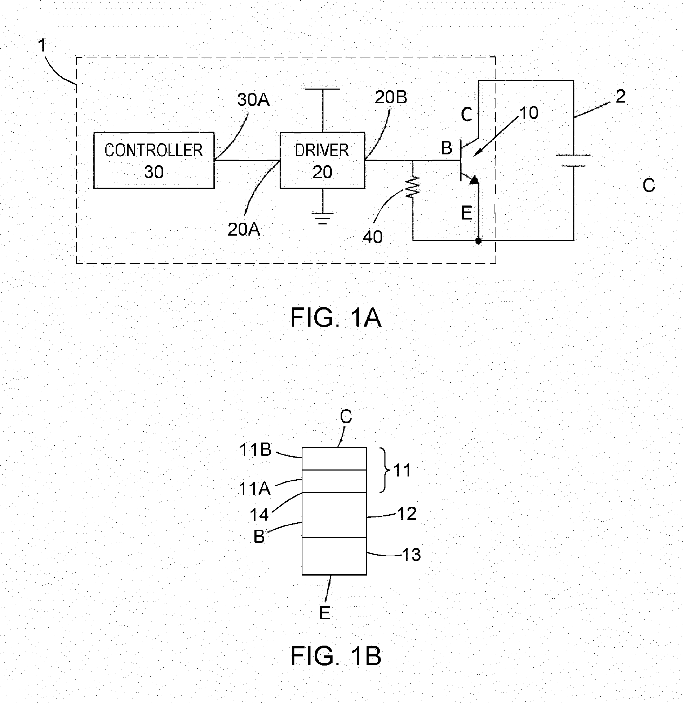

With reference to Fig 1, there is shown control circuitry 1 for controlling current flow through an external circuit 2 (shown notionally).

The control circuitry 1 includes a power bipolar junction transistor (BJT) 10, a driver circuit 20, a controller 30 and a bypass resistor 40.

The BJT 10 is connected about its collector C and emitter E terminals into the external circuit 2. The bypass resistor 40 is connected between the emitter E and base B terminals of the BJT 10 to provide a bypass connection between the base B and emitter E terminals of the BJT 10.

The external circuit may operate at high voltages, e.g. ≥ 600 V with current flow through the collector C of ≥ 32A.

With reference Fig 1B, the BJT 10 comprises a collector region 11, a base region 12 and an emitter region 13; the base region 12 interposed between the collector region 11 and emitter region 13. To handle the high voltages experienced within the external circuit 2 without breaking down, the BJT 10 includes a drift region 11A; a weakly doped region of semiconductor material that forms part of the collector region 11. The collector region 11 also includes a strongly doped region 11B of the same type making connection with the collector terminal C.

In the illustrated example the BJT 10 has a NPN structure and therefore both the drift region 11A and strongly doped region 11B are of the N type. The drift region interfaces directly with the base region 12 to provide one of the diode junctions 14 of the BJT 10.

Figure 1B illustrates the BJT 10 as a discrete component for ease of illustration. Nevertheless, it will be appreciated that the transistor 10 may be integrally formed (e.g. as a vertical transistor) in a semiconductor die with, for example, circuitry providing the driver circuit 20 and/or controller 30 and/or one or more other BJTs for controlling other external circuits or circuit fragments.

Referring back to Fig 1A, the controller 30 comprises an output 30A. The driver circuit 20 comprises an input 20A connected to the controller output 30A and an output 20A connected to the base terminal B of the BJT 10.

The controller 30 is adapted to generate a first control signal at output 30A for receipt at the input 20A of the driver circuit 20. The driver circuit 20 is adapted to vary a tri-state driver signal at its output 20B between an ON state (e.g. high), OFF state (e.g. low(ground) and FLOATING state (high impedance) in response to the received control signal to control current flow between the emitter E and collector C terminals of the BJT 10.

The resistive value of the bypass resistor 40 is such that:
when the driver signal is ON the current through the bypass resistor 40 is smaller than the current at the output 20B of the driver 20 so as not to inhibit switching on of the BJT 10; and
that whilst the BJT 10 is ON and the driver signal is FLOATING, current will discharge from the base, and thus bring the voltage of the base towards that of the emitter, at a slow enough rate that the BJT remains ON until the driver signal switches to OFF.

The controller 30 may be implemented by an external microcontroller. Alternatively, the circuitry of the controller 30 may be integrally formed in the same semiconductor die in which the BJT 10 and/or the driver circuitry 20 is formed. In the latter case the circuitry may include one or more counters, subtractors and comparators. For example, the subtractor may calculate the time required for each of the three states of the driver 20 output and the comparator may be used to compare this target time with the current time period. These may be implemented by digital or analogue circuitry. In a preferred embodiment the entire control circuitry 1 may be provided by a single discrete semiconductor device. In such an arrangement, the transistor 10, driver 20, controller 30 and bypass resistor would all be integrally formed on a single semiconductor die. A description of how this may be implemented can be found in WO2019/155239A1.

In one implementation the controller 30 may be configured to produce a tri-state logic signal at its output 30A, e.g. being of one of three states: high (Vcc), low (ground) and high impedance (floating).

The controller 30 may be adapted to receive bi-state signal or a periodic pulse when the BJT 10 needs to be switched on or off.

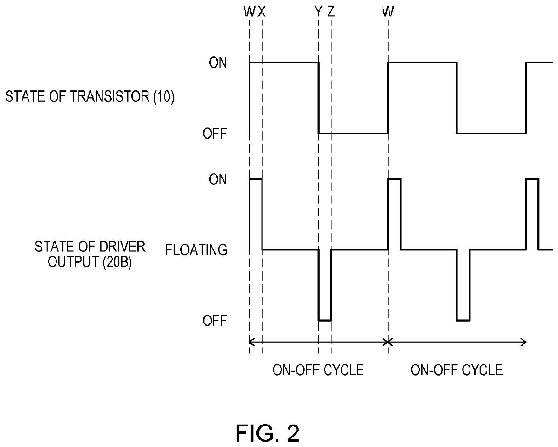

Figure 2 is a timing diagram showing two complete ON-OFF switching cycles of the BJT 10 illustrating how, under the controller's 30 control, the driver circuit 20 times the tri-state control signal to switch the BJT 10 ON and OFF.

The top line illustrates the changing state of the BJT 10 between ON and OFF over the switching period. The bottom line illustrates the changing state of the driver signal between ON, OFF and FLOATING.

At the beginning of the cycle (W) the driver signal switches from FLOATING to ON switching the BJT 10 ON such as to allow current flow through external circuit 2. Shortly after the driver signal switches back to FLOATING (X). However, by virtue of the flooded drift region 11A, the BJT 10 remains ON.

The charge within the drift region 11A slowly drains through the base B and the bypass resistor 40. At (Y) the driver signal switches to OFF switching the BJT 10 OFF. Because the charge within the drift region 11A has been draining between (X) and (Y) the time required to establish a depletion region about the diode junction 14 is reduced.

Shortly afterwards, the driver signal switches back to FLOATING (Z); the BTJ 10 remains OFF. The bypass resistor 40 provides a path for leakage current out of the base 12 from the collector 11 ensuring that the breakdown voltage Vce of the BJT 10 is maintained. Without the bypass resistor 40, the voltage at the base would rise towards that of the collector reducing the voltage across the collector and base and thus the size of the depletion region about the reverse biased diode junction 14,

The controller 30 is adapted to control timing of switching between the tri-states such that the duration W-X is shorter than duration X-Y, and that duration Y-Z is shorter than duration Z-W. As such the duration within a switching cycle that the output of the driver circuit 20 is FLOATING is longer than the combined time the output is ON and OFF. W-X may be less than 5% of the duration of X-Y, and Y-Z less than 5% of the duration of Z-W. The sum of W-X and Y-Z, i.e. the total duration that the driver output is either ON or OFF, is less than 5% (<5% duty cycle) of a complete ON-OFF cycle W-W of the transistor 10. In this way losses within the driver circuit 20 are significantly reduced.

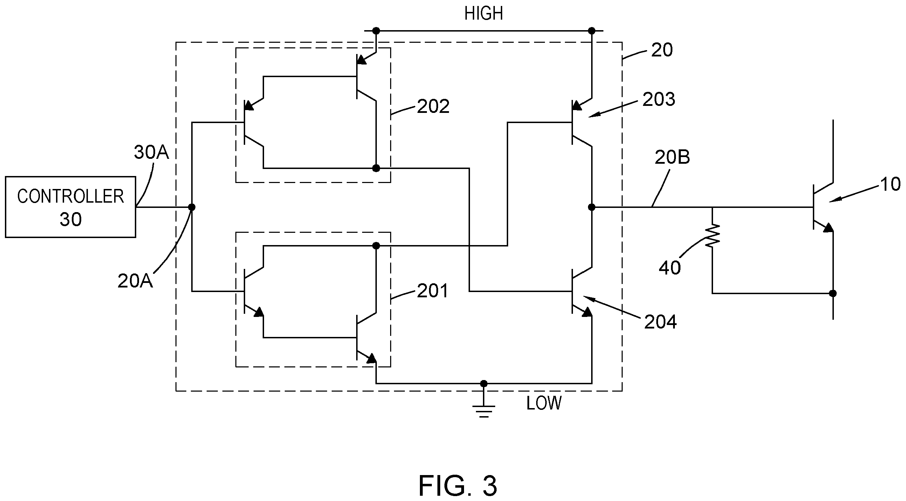

Figure 3 illustrates an example driver circuit 20 arrangement. The driver circuit 20 includes complementary first and second Darlington pairs 201 202 that are connected to base terminals of a respective high side transistor 203 and low side transistor 204.

The controller 30 is adapted to provide a tri-state control signal ON, OFF or FLOATING, at its output 30A which is seen at the input 20A of the driver circuit 20.

When the control signal is ON the first Darlington pair 201 is switched on which switches on the high side transistor 203. Current flows into the base B of the BJT 10 switching the BJT 10 ON. The second Darlington pair 202 and low side transistor 204 remain off.

When the control signal is OFF the first Darlington pair 201 is switched off which switches off the high side transistor 203. The second Darlington pair 202 is switched ON which switches on the low side transistor 204. Current flow into the base B ceases. Any remaining charge within the collector 11A drains out of the base terminal B and the BJT 10 turns OFF.

When the control signal is FLOATING both the high side and low side transistors 203 204 are off leaving the output 20B floating (high impedance).

Darlington pairs 201 202 are used to increase the current through the base of the BJT 10 to compensate for the low gain of the BJT 10 - a consequence of the BJT's 10 relatively large and low doped base region 12 which, in combination with the collector drift region 11A, provides the BJT 10 with a high breakdown voltage.

The first Darlington pair 201 comprises NPN transistors and drive a PNP high side transistor 204, whereas the second Darlington pair 202 comprises PNP transistors and drive a NPN low side transistor 204. This arrangement balances gains between the two complementary sides.

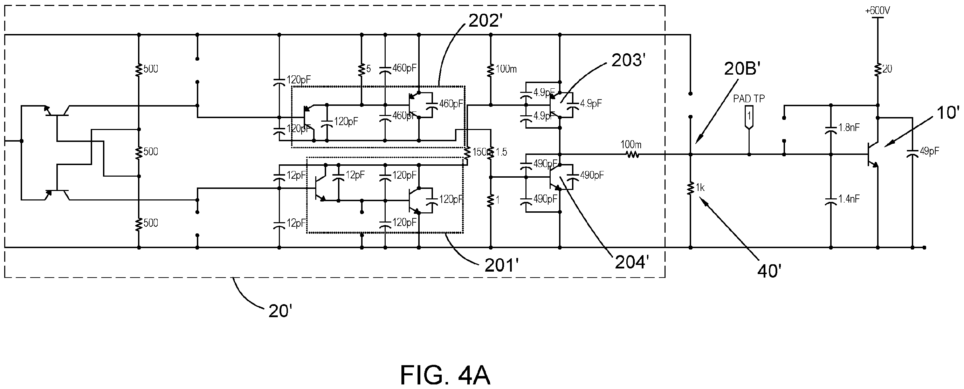

Figure 4A illustrates a driver circuit 20' that is a modelled practical implementation of the driver circuit 20 of Fig 3.

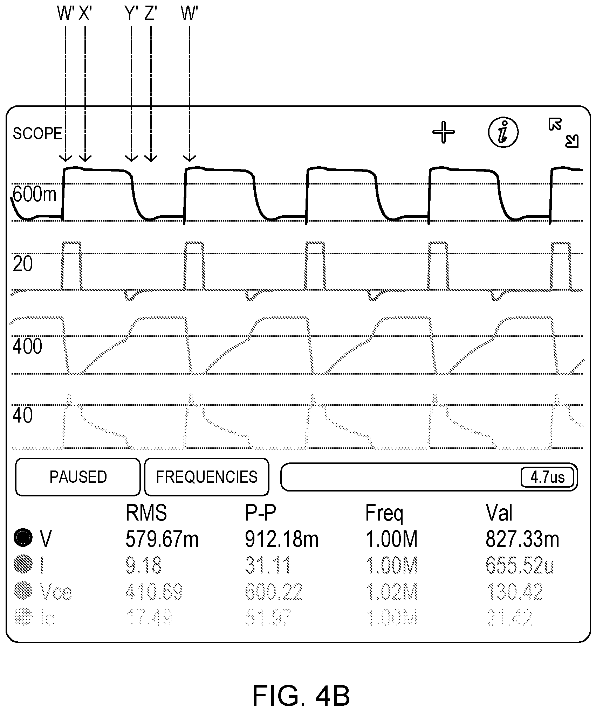

Figure 4B illustrates modelled voltage and current at various points in the circuit of Fig 4A over the course of approximately four and half switching cycles of the BJT 10'.

The uppermost line shows the change in voltage at the output 20B' of the driver circuit 20'. The second uppermost line shows change in current through the base terminal of the BJT 10'. The second from bottom line shows the changing voltage Vce across the collector and emitter of the BJT 10' and the bottom line shows the changing current through the collector C of the BJT 10'.

Lines W' X' Y' and Z' indicate corresponding transitions in the timing of the driver signal described in relation to Fig 2. The second uppermost line shows a short pulse of current into the base terminal B of the BJT 10' following switching on of the high side transistor 203' before both high side and low side transistors 203' 204' are switched off at X'. There follows a gradual drop in the current through the collector C and a corresponding increase in Vce until Y' when the low side transistor 204' is switched on. Whereupon there is a small reversal of current out through the base terminal B of the BJT 10' as a consequence of the collector drift region 11A of the BJT 10' discharging.

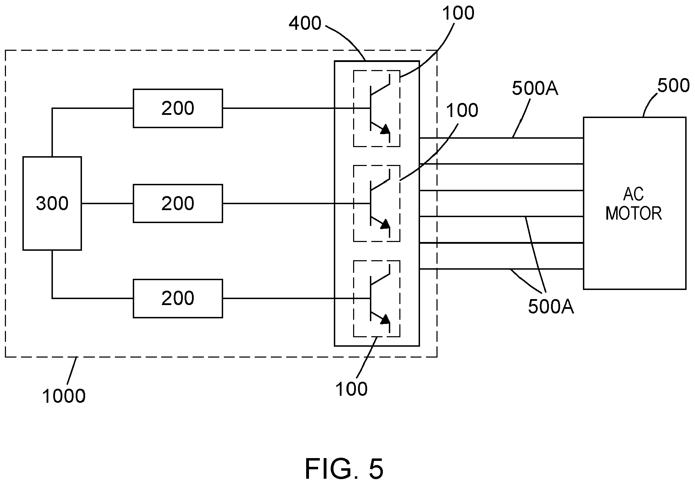

Figure 5 is a simplified diagram illustrating application of the above described control circuitry in a motor driver 1000 for a multiple phase alternating current electric motor 500.

The driver 1000 controls the switching of current through multiple windings 500A, in this example six, of the electric motor 500. The motor driver 1000 includes a switching circuit 400 comprising a separate BJT 100 associated with each winding 500A (only three shown in Fig) to switch current through it. Each BJT 100 is controlled by a separate driver circuit 200 (again only three shown in Fig). Each driver circuit 200 has an input arranged to receive a different tri-state control signal from controller 300. The control signal is used by each driver circuit 200 to control the state of their respective BJT 100. Although not shown, a separate bypass resistor connects across the base and emitter terminals of each BJT 100 in the manner described above.

The circuitry thereby provides an alternative to the use of IGBTs and SiC MOSFETs in such applications where switching of high voltage is required.

In a variant to Fig 5 a separate controller 300 may be associated with each transistor 100. Where so, the transistor 100 with respective driver 200 and controller 300 may be integrated in a single semiconductor die and as such may be provided by a four pin discrete semiconductor device. Two pins of the device are assigned to the emitter and collector of the BJT 100, a third pin assigned to the base of the BJT 10 via the driver 200, and a fourth pin assigned to an input of the controller 300 to receive an, optionally bi-state, input signal used to instruct when to turn the BJT 100 ON and OFF.

The control circuits described above may comprise a PNP type BJT, mutatis mutandis, instead of a NPN BJT.

Though less preferred because it would compromise the breakdown voltage of the transistor, the bypass resistor 40 may be omitted.

## Claims

1. A circuit (1) comprising:
a bipolar junction transistor, BJT, (10) having a collector drift region (11A);
a controller (30);
a driver circuit (20) having an input (20A) adapted to receive a control signal from the controller (30), and an output (20B) connected to a base terminal B of the BJT (10); the driver circuit (20) adapted to switch the state at the output (20B) in response to the received control signal between:
an ON state that switches the transistor (10) into an ON state;
an OFF state that switches the transistor (10) into an OFF state;
and a floating state;
and **characterised in that** the controller (30) is adapted to operate the driver circuit (20) such that within a ON-OFF switching cycle of the BJT (10), the output of the driver circuit (20) is in the floating state for longer than it is in the ON state and the OFF state.

2. A circuit (1) according to claim 1 comprising a bypass connection between the base terminal (b) of the BJT (10) and an emitter terminal (E) of the BJT (10), the bypass connection including a load (40) with a resistance sufficient that, when in operation, current through the bypass connection when the BJT (10) is OFF is small compared with the current through the base terminal (B) when the BJT (10) is ON.

3. A circuit (1) according to claim 1 or 2 wherein the controller (30) is adapted to operate the driver circuit (20) such that the output (20B) of the driver circuit (20) is in the floating state for equal or over 50% of a complete ON-OFF cycle of the BJT (10).

4. A circuit (1) according to claim 3 wherein the controller (30) is adapted to operate the driver circuit (20) such that the output (20B) of the driver circuit (20) is in the floating state for equal or equal or over 95% of a complete ON-OFF cycle of the BJT (10).

5. A circuit (1) according to any previous claim wherein the ON-OFF switching cycle comprise the following transitions in the states at the driver circuit output (20B) : ON to FLOATING, from FLOATING to OFF, from OFF to FLOATING and from FLOATING to ON.

6. A motor driver(1000) for a multi-phase electric-motor (500) comprising:
the circuit of any claim 1-5, wherein said circuit comprises multiple of the bipolar junction transistors (BJTs) (100) for switching current through windings (500A) of the multi-phase electric-motor (500);
a separate driver circuit (200) associated with each BJT (100), each driver circuit (200) comprising an input adapted to receive a control signal from the controller (300), and an output connected to a base terminal of its respective BJT (100); each driver circuit (200) adapted to switch the state at its output in response to the received control signal between:
an ON state that switches the transistor into an ON state;
an OFF state that switches the transistor into an OFF state;
and a floating state;
and wherein the controller (300) is adapted to operate the separate driver circuits (200) such that during a complete ON-OFF switching cycle of each BJT (100), the output of each driver circuit (200) is in the floating state for longer than it is in the ON state and the OFF state.

## Patentansprüche

1. Ein Kreislauf (1) bestehend aus:
Einen Bipolartransistor (10) (BPT) mit einer Kollektordriftregion (11A); einem Regler (30);
Einer Treiberschaltung (20) mit einem Eingang (20A), der in der Lage ist, ein Kontrollsignal vom Regler (30) zu erhalten, und einen Ausgang (20B), der an einen Basisanschluss B des BPT (10) angeschlossen ist; der Treiberschaltung (20), die in der Lage ist, den Status des Ausgangs (20B) in Reaktion auf das empfangene Kontrollsignal zu empfangen und folgendermaßen umzuschalten:
In einen ON-Status, mit dem der Transistor (10) in einen ON-Status geschaltet wird;
In einen OFF-Status, mit dem der Transistor (10) in einen OFF-Status geschaltet wird;
und einen Schwebezustand;
und der dadurch charakterisiert ist, dass der Regler (30) in der Lage ist, die Treiberschaltung (20) so zu bedienen, dass sich der Ausgang des Treiberschaltkreises (20) im ON-OFF-Schaltzyklus des BPT (10) länger im Schwebezustand als im ON- oder OFF-Zustand befindet.

2. Ein Kreislauf (1) nach Anspruch 1, der aus einer Umgehungsverbindung zwischen dem Basisanschluss (b) des BPT (10) und einem Emitteranschluss (E) des BPT (10) besteht, wobei die Umgehungsverbindung eine Last (40) mit einem Widerstand hat, der im Betrieb ausreicht, um zu erreichen, dass die Spannung durch die Umgehungverbindung bei BPT (10) auf OFF klein ist im Vergleich zur Spannung durch den Basisanschluss (B) bei BPT (10) auf ON.

3. Ein Kreislauf (1) gemäß Anspruch 1 oder 2, wobei der Regler (30) in der Lage ist, die Treiberschaltung (20) so zu bedienen, dass der Ausgang (20B) der Treiberschaltung (20) in einem Schwebezustand ist, der einem vollständigen ON-OFF-Zyklus des BPT entspricht oder über 50 % liegt.

4. Ein Kreislauf (1) gemäß Anspruch 3, wobei der Regler (30) in der Lage ist, die Treiberschaltung (20) so zu bedienen, dass der Ausgang (20B) der Treiberschaltung (20) in einem Schwebezustand ist, der einem vollständigen ON-OFF-Zyklus des BPT entspricht oder über 95 % liegt.

5. Ein Kreislauf (1) gemäß einem der obigen Ansprüche, wobei der ON-OFF-Schaltzyklus die folgenden Übergänge in den Zuständen der Treiberschaltungsausgänge (20B) umfasst: ON zu SCHWEBEND, SCHWEBEND zu OFF, OFF zu SCHWEBEND und SCHWEBEND zu ON.

6. Ein Motortreiber (1000) für einen Mehrphasen-Elektromotor (500) bestehend aus:
Dem Kreislauf aus den Ansprüchen 1 bis 5, wobei der besagte Kreislauf mehrere Bipolartransistoren (BJT) (100) umfasst, um die Spannung durch die Gewinde (500A) des Mehrphasen-Elektromotors (500) zu schalten.
Einer Treiberschaltung (200) verbunden mit jedem BPT (100), jede Treiberschaltung (200) umfasst einen Eingang, der in der Lage ist, ein Kontrollsignal vom Regler (300) zu erhalten, und einen Ausgang, der an einen Basisanschluss des jeweiligen BPT (100) angeschlossen ist. Jede Treiberschaltung (200), die in der Lage ist, den Status des Ausgangs in Reaktion auf das empfangene Kontrollsignal zu empfangen und folgendermaßen umzuschalten:
Einen ON-Status, mit dem der Transistor in einen ON-Status geschaltet wird;
Einen OFF-Status, mit dem der Transistor in einen OFF-Status geschaltet wird;
und einen Schwebezustand;
und wobei der Regler (300) in der Lage ist, die getrennten Treiberschaltungen (200) so zu bedienen, dass während eines kompletten ON-OFF-Schaltzyklus jedes BPT (100) der Ausgang eines jeden Treiberschaltkreises (200) sich länger im Schwebezustand als im ON- oder OFF-Zustand befindet.

## Revendications

1. Un circuit (1) comprenant :
un transistor bipolaire, (bipolar junction transistor, BJT), (10) ayant une zone de dérive de collecteur (11A) ; un dispositif de commande (30) ;
un circuit de commande (20) ayant une entrée (20A) adaptée pour recevoir un signal de commande du dispositif de commande (30), et une sortie (20B) raccordée à une broche Base B du transistor bipolaire (BJT) (10) ; le circuit de commande (20) adapté pour changer l'état à la sortie (20B) en réponse au signal de commande reçu entre :
un état Passant qui commute le transistor (10) pour passer à un état Passant;
un état Bloqué qui commute le transistor (10) pour passer à un état Bloqué;
et un état flottant (floating) ;
et **caractérisé par le fait que** le dispositif de commande (30) est adapté pour faire fonctionner le circuit de commande (20) de sorte que dans un cycle de commutation Passant-Bloqué du transistor bipolaire (BJT) (10), la sortie du circuit de commande (20) est en état flottant (floating) pendant plus longtemps qu'il ne l'est en état Passant et en état Bloqué.

2. Un circuit (1) selon la revendication 1, comprenant un raccord de dérivation entre la broche Base (b) du transistor bipolaire (BJT) (10) et une broche Émetteur (E) du transistor bipolaire (BJT) (10), le raccord de dérivation incluant une charge (40) ayant une résistance suffisante pour que, lorsqu'il est en fonctionnement, le courant traversant le raccord de dérivation quand le transistor bipolaire (BJT) (10) est bloqué, est faible par rapport au courant traversant la broche Base (B) lorsque le transistor bipolaire (BJT) (10) est passant.

3. Un circuit (1) selon la revendication 1 ou 2, dans lequel le dispositif de commande (30) est adapté pour faire fonctionner le circuit de commande (20) de sorte que la sortie (20B) du circuit de commande (20) est en état flottant (floating) pendant une durée égale ou supérieure à 50 % d'un cycle Passant-Bloqué complet du transistor bipolaire (BJT) (10).

4. Un circuit (1) selon la revendication 3, dans lequel le dispositif de commande (30) est adapté pour faire fonctionner le circuit de commande (20) de sorte que la sortie (20B) du circuit de commande (20) est en état flottant (floating) pendant une durée égale ou égale ou supérieure à 95 % d'un cycle Passant-Bloqué complet du transistor bipolaire (BJT) (10).

5. Un circuit (1) selon l'une des revendications précédentes, dans lequel le cycle de commutation Passant-Bloqué comprend les transitions suivantes dans les états à la sortie du circuit de commande (20B) : PASSANT à FLOTTANT, de FLOTTANT à BLOQUÉ, de BLOQUÉ à FLOTTANT et de FLOTTANT à PASSANT.

6. Un pilote de moteur (1000) pour un moteur électrique polyphasé (500) comprenant :
le circuit selon l'une des revendications 1 à 5, dans lequel ledit circuit comprend plusieurs transistors bipolaires (BJT) (100) pour commuter le courant à travers les bobines (500A) du moteur électrique polyphasé (500) ;
un circuit de commande séparé (200) associé à chaque transistor bipolaire (BJT) (100), chaque circuit de commande (200) comprenant une entrée adaptée pour recevoir un signal de commande du dispositif de commande (300), et une sortie connectée à une broche Base de son transistor bipolaire (BJT) respectif ( 100) ; chaque circuit de commande (200) adapté pour commuter l'état à sa sortie en réponse au signal de commande reçu entre :
un état Passant qui commute le transistor (10) pour passer à un état Passant;
un état Bloqué qui commute le transistor (10) pour passer à un état Bloqué;
et un état flottant (floating) ;
et dans lequel le dispositif de commande (300) est adapté pour faire fonctionner les circuits de commande séparés (200) de sorte que dans un cycle complet de commutation Passant-Bloqué de chaque transistor bipolaire (BJT) (100), la sortie de chaque circuit de commande (200) est en état flottant (floating) pendant plus longtemps qu'il ne l'est en état Passant et en état Bloqué.
